# EUROPEAN PATENT SPECIFICATION

(11) **EP 1 975 725 B1**
(45) Date of publication and mention of the grant of the patent: **19.12.2012**
(21) Application number: 08004856.4
(22) Date of filing: 14.03.2008
(51) Int. Cl.: G03F 7/30

(54) **Standard image pattern, developer evaluation method for planographic printing plate using the standard image pattern, and quality control method for planographic printing plate using the standard image pattern**
Standardbildmuster, Entwicklerevaluierungsverfahren für Flachdruckplatten mit dem Standardbildmuster und Qualitätskontrollverfahren für Flachdruckplatten mit dem Standardbildmuster
Motif d'image standard, procédé d'évaluation de développeur pour plaque d'impression planographique utilisant le motif d'image standard, et procédé de contrôle de qualité pour plaque d'impression planographique utilisant le motif d'image standard

(30) Priority: 30.03.2007 JP 2007092894
(43) Date of publication of application: 01.10.2008
(73) Proprietor: FUJIFILM Corporation, Minato-ku Tokyo (JP)
(72) Inventor: Aono, Koichiro, Haibara-gun Shizuoka-ken (JP); Yagi, Yoshihiro, Haibara-gun Shizuoka-ken (JP); Kobayashi, Fumikazu, Haibara-gun Shizuoka-ken (JP)
(74) Representative: HOFFMANN EITLE

(56) References cited:
- JP-A- 8 044 076
- US-A1- 2007 002 384
- US-B1- 6 433 891
- US-B1- 6 798 537

## Description

### Field of the Invention

The present invention relates to a standard image pattern for managing a plate making process of a printing plate, a developer evaluation method for a planographic printing plate and a quality control method for a planographic printing plate, both of which methods each use the standard image pattern. More specifically, the present invention relates to a standard image pattern for image evaluation, which is suitable for a positive type planographic printing plate for infrared laser, which plate can be made directly from a digital signal of a computer or the like (so-called direct plate making), and also relates to a quality control method for a planographic printing plate using the standard image pattern.

### Description of the Related Art

In the printing/plate-making industries, a standard image used for production control of printing is referred to as a control strip, and in most cases, a control strip is printed, as a small standard image, in a blank space section at an end of an image required as printed matter. On the basis of the control strip, the finished state of the printed matter in the plate-making/printing process is checked by visual observation or by measurement of density, and the obtained result is fed back to the previous processes. Thus, quality control is performed.

In recent years, there have been increased cases in which an infrared laser is used as a light source for exposure when a plate is made directly from digital data of a computer or the like. In the positive type planographic printing plate for infrared laser described above, generally, the latitude of an image recording layer in relation to the degree of activity of a developer is small, and in order that stable images are continuously formed, control of processes becomes important. Usually, when a photosensitive planographic printing plate is developed, an automatic processor is used which has a replenishment mechanism by which the sensitivity of a developer is maintained at a constant level as possible, and a method for adding a high-activity replenishing solution is used to prevent deterioration of development performance caused by decrease in pH of the developer (for example, see Japanese Patent Application Laid-Open (JP-A) No. 8-44076). However, this positive type planographic printing plate for infrared laser has a small latitude as described above, and therefore, the image formability significantly varies due to change in the degree of activity of the developer, and the development performance improves too much due to addition of a high-activity replenishing solution. Thus, problems in the quality of a planographic printing plate are apt to occur, such as the generation of defects in an image section, or undesirable development of halftone dots, thin lines and the like.
Further, in recent years, there have been increased demands for obtaining a more highly fine image. To this end, stabilization of formation of halftone dots in detailed portions is required, and the variation in the image formability caused by changes in the degree of activity of a developer as described above has become a greater problem than ever before. Accordingly, a standard image pattern (a control strip) that is suitable for evaluating the formability of halftone dots in a planographic printing plate such as as described above, and also a quality control method for constantly maintaining the formability of halftone dots, are strongly desired.

US 6,798,537 B1 discloses two novel techniques for digital color halftoning with green-noise stochastic dither patterns generated by homogeneously distributing minority pixel clusters. The first technique employs error diffusion with output-dependent feedback such that the overlapping of pixels of different colors can be regulated for increased color control. The second technique uses a green-noise mask which is a dither array designed to create green-noise halftone patterns. The green-noise mask is constructed to also regulate the overlapping of different colored pixels. As is the case with monochrome image halftoning, both techniques are tunable, allowing for large clusters in printers with high dot-gain characteristics, and small clusters in printers with low dot-gain characteristics.

This document also discusses briefly an alternative to AM and FM halftoning, published in the report of the "*Eigh th International Congress on Advances in Non-Impact Printing Technologies*". According to this discussion, error correction with output dependent feedback is an AM-FM hybrid which creates the illusion of continuous tone by producing a stochastic patterning of dot clusters which vary both in their size and in their separation distance. This disclosure does not suggest that the image pattern comprises on the one hand a plurality of AM halftone images and on the other hand a plurality of FM halftone images, and it does not disclose at each of a plurality of FM halftone images is positioned adjacent to a respective one of a plurality of AM halftone images.

US 6,433,891 B1 describes a stochastic screening mask for rendering halftone images. A filter controlled force masking method is used to vary the mask patterns from regularity to randomness. Dot size (amplitude), dot number (frequency), and dot shape are modulated integrally at each gray level during the generation of the mask. The single pixel limit for blue noise making is broken down by this approach. The halftone patterns generated with this method can have visually pleasing blue noise attribute.

US 2007/0002384 Al describes a method of generating a digital AM halftone image output which includes the steps of: (a) receiving a grey scale image from an image source; (b) generating an image component from the grey scale image; and (c) producing the digital AM halftone image output. The digital AM image output includes a plurality of halftone dots, each of which comprises at least one ink-receptive portion and at least one non-receptive portion. Patterns of halftone dots prepared in this manner may be sent as a digital output to an platesetter for producing a printing plate.

An object of the present invention is to provide a standard image pattern for controlling a plate making process, in which a plate making condition for direct plate making, particularly, the activity state of a developer is easily determined.

According to a first aspect of the invention there is provided a standard image pattern for use in controlling a process of making printing plates, comprising:
a plurality of AM halftone images, each of which is formed of dots according to Amplitude Modulation Screening, and each of which has an area coverage that is different from that of the others; and
a plurality of FM halftone images, which are formed of dots according to Frequency Modulation Screening, each image of which is adjacent to a respective one of the plurality of the AM halftone images, and which have a predetermined area coverage.

A second aspect of the invention provides a method for evaluating a developer for a planographic printing plate, comprising:
producing a standard plate by exposing a photosensitive planographic printing plate precursor to form the standard image pattern and then developing the image with a standard developer;
producing a subject developer evaluation plate in the same manner as that of the standard plate except that the developing is performed by using a developer to be evaluated; and
comparing the dot area coverage resulted resulting from the standard plate with that resulting from the subject developer evaluation plate.

A third aspect of the invention provides a method for controlling quality of a planographic printing plate, comprising:
producing a standard plate by exposing a photosensitive planographic printing plate precursor to form a standard image pattern and then developing the image with a standard developer;
producing a subject developer evaluation plate in the same manner as that of the standard plate except that the developing is performed by using a developer to be evaluated;
comparing the dot area coverage resulting from the standard plate with that resulting from the subject developer evaluation plate; and
controlling a conditionadjusting a condition of at least one of the exposing and the developing in a case where the difference between the dot area coverage resulting from the standard plate and that resulting from the subject developer evaluation plate is equal to or larger than a predetermined value.

In one embodiment of the third aspect of the invention, the method for controlling quality of a planographic printing plate further comprises performing, at least once in this order, the following cycle comprising:
producing a new subject developer evaluation plate in the same manner as that of the standard plate except that the developing is performed by using a developer to be evaluated, and at least one of the exposing and the developing is performed under the adjusted condition of at least one of the exposing and the developing;
comparing the dot area coverage resulting from the standard plate with that resulting from the new subject developer evaluation plate; and
adjusting a condition of at least one of the exposing and the developing in a case where the difference between the dot area coverage resulting from the standard plate and that resulting from the new subject developer evaluation plate is equal to or larger than a predetermined value.

### BRIEF DESCRIPTION OF THE DRAWINGS

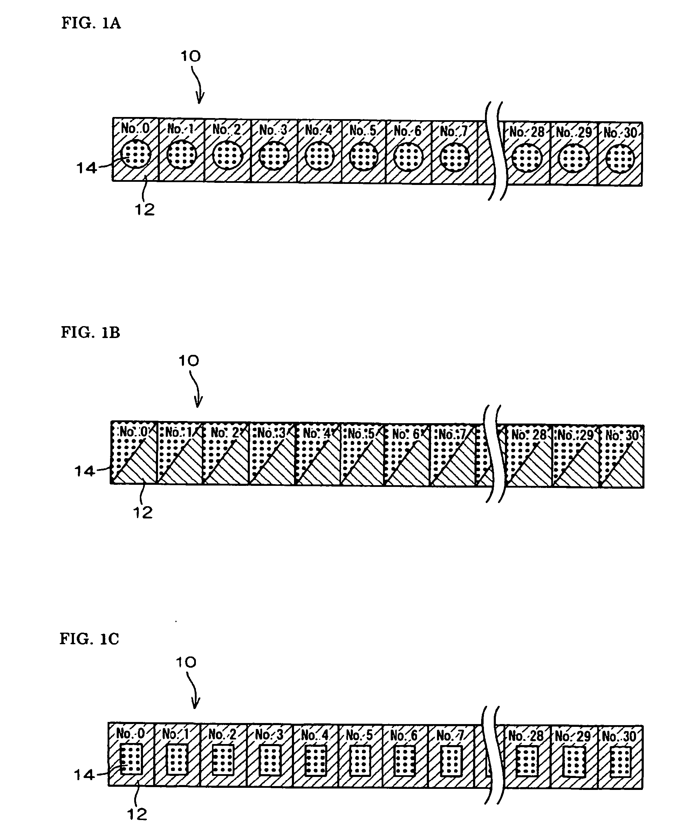

Fig. 1A is a model diagram showing a region in which an AM halftone image is formed, and a region in which an FM halftone image is formed, which regions are formed adjacently, in a standard image pattern according to an embodiment of the present invention.
Fig. 1B is another model diagram showing a region in which an AM halftone image is formed, and a region in which an FM halftone image is formed, which regions are formed adjacently, in a standard image pattern according to an embodiment of the present invention.
Fig. 1C is still another model diagram showing a region in which an AM halftone image is formed, and a region in which an FM halftone image is formed, which regions are formed adjacently, in a standard image pattern according to an embodiment of the present invention.

The following describes further a developer evaluation method in which the activity of a developer can be accurately evaluated based on results of image evaluation obtained by using the aforementioned standard image pattern, and also provides a quality control method for a planographic printing plate, in which due to feedback of the obtained results to an exposure or development process, the quality of a planographic printing plate is maintained constantly, and uniform images can be continuously formed, which method is particularly suitable for a planographic printing plate having an image recording layer adapted to infrared laser.

As a result of intensive studies, the present inventors have found that a standard image pattern that allows accurate evaluation can be obtained, as a standard image pattern having halftone dots whose area coverages are each varied in stages, by arranging two different types of halftone dots in proximity to each other, and also forming a pattern in which the two types of halftone dots are varied in stages. Further, the inventors also have found that by using the image pattern, and by subjecting a planographic printing plate which has been subjected to exposure under a specified condition to plate making under a standard condition, thereafter subjecting a similar planographic printing plate to plate making under a condition intended for evaluation, and comparing the obtained plates with each other, images formed thereon can be simply evaluated. Moreover, the inventors have also found that due to feedback of the evaluation results, quality control of planographic printing plates can be easily carried out.

### Standard Image Pattern

The standard image pattern (control strip) according to an embodiment of the present invention is characterized in that an AM screening image chart in which plural AM halftone images formed by an AM screening system are continuously arranged while the area coverages thereof are changed in stages, and an FM screening image in which FM halftone images formed by an FM screening system are formed at a predetermined area coverage, that is, at a fixed area coverage controlled according to an intended purpose are arranged such that the FM halftone images are disposed in proximity to the AM halftone images whose dot area coverage varies in stages.

The "FM screening" is an abbreviation for "Frequency Modulation Screening" and is a printing system based on a halftone dot pattern using frequency modulation technology. In this system, the degree of density of dots represents variable density of an image.

The FM screening represents the variable density of a recorded image by a collective density of indeterminate-form dots having no regularity, that is, a system in which images each formed by a relatively small number of minute dots, such as four dots in total (=2x2), are dispersed in a two-dimensional plane, and thus, the gradation of the image is represented.

On the other hand, in the AM screening which is another halftone image used in the standard image pattern of the present invention, halftone dots of a regular shape, having the shape of net, that is, a so-called extremely small checkered pattern, are used.

In the AM screening, a halftone dot image of the minimum unit is structured by, as an example, 196 dots in total obtained by 14 (dots in the horizontal direction) x 14 (dots in the vertical direction), or a relatively large number of minute dots. The halftone images thus obtained are recorded in such a manner as to be arranged in the two-dimensional plane, whereby a variable density image is formed and gradation representation thereof is performed.

Usually, a halftone region is represented by the AM screening (AM halftone dots) or FM screen (FM halftone dots), but in order to obtain highly fine printed matter, it is necessary to form halftone images of the AM screening and FM screen, which images are highly fine and uniform over the entire surface of the planographic printing plate. Thus, control of the image density as described above is important in the quality control of printed matter.

The standard image pattern provides plural AM halftone images, each of which is formed of dots according to the AM screening, and each of which has an area coverage that is different from that of the others, and plural FM halftone images, which are formed of dots according to the FM screening, which have a predetermined area coverage, and which are respectively adjacent to the plurality of the AM halftone images so that the AM halftone image and FM halftone images can be easily visually observed. Namely, the standard image pattern of the present invention is formed by a combination of an image chart in which AM halftone images are continuously arranged with the dot area coverages thereof varying in stages, and images in which FM halftone images having a fixed area coverage are arranged in proximity to the AM halftone images, respectively. The region having the AM halftone images being formed therein, and the region having the FM halftone images being formed therein, which regions are formed adjacently, can be arbitrarily selected.

Specific examples each showing the region, in which halftone images are formed, in the standard image pattern of the present invention will be hereinafter described, while the present invention is not limited by these examples.
Figs. 1A to 1C are model diagrams which each show a region 12 having an AM halftone image formed therein, and a region 14 having an FM halftone image formed therein, which are formed adjacently in the standard image pattern 10 of the present invention. In Figs. 1A to 1C, the region 12 having the AM halftone image formed therein is indicated by slanting lines, and the region 14 having the FM halftone image formed therein is indicated by halftone dots. These drawings each show examples of positions of the regions 12, each of which having an AM halftone image, and the regions 14, each of which having an FM halftone image, in an embodiment in which the area coverage of the AM halftone images are varied stepwise in 31 stages from No. 0 to No. 30. The number of stages of change can also be appropriately determined according to an intended purpose such as a required degree of evaluation accuracy.
The region having the AM halftone image formed therein, and the region having the FM halftone image formed therein have several embodiments as shown in, for example, Figs. 1A to 1C. Fig. 1A shows an embodiment in which a circular region is formed in the vicinity of the center of each rectangular region, an AM halftone image is formed in a peripheral rectangular region, and an FM halftone image is formed within the central circular region. Fig. 1B shows an embodiment in which a rectangular region is divided into two sections by a diagonal straight line, an AM halftone image is formed in one region, and an FM halftone image is formed in the other region. Fig. 1C shows an embodiment in which a rectangular region has a rectangular region of a different surface area in the vicinity of the center thereof, an AM halftone image is formed in the peripheral rectangular region, and an FM halftone image is formed in the central rectangular region.
As shown in Figs. 1A to 1C, plural sets of halftone dot regions having different area coverages are formed, whereby the standard image pattern of the present invention is structured.

Particularly, as shown in Fig. 1A, it is preferable from the viewpoint of being easily viewable that the FM halftone image is formed in the central circular region, and the peripheral portion of the circular region is provided as the region having the AM halftone image formed therein.
Considering the minimum measurement area of a densitometer, preferably, the sizes of regions each having halftone dots formed therein are set such that at least one side of a rectangular region is 7 mm or more and the diameter of the circular region is 7 mm or more.

The FM halftone image having a fixed area coverage is preferably a halftone image in which circular images having the diameter of approximately 10 to 75 µm are randomly arranged. Further, the dot area coverage of the FM halftone image to be formed at a predetermined area coverage is preferably set in the range from 30 % to 70 %.
Further, the AM halftone image formed in the vicinity of the FM halftone image having a fixed area coverage preferably includes a specified number of screen lines in the range from 80 lines per inch to 300 lines per inch. The change of dot area coverage is preferably set such that, on the standard scale, the minimum value is 30% or thereabouts, and the maximum value is 60 % or thereabouts. When the dot area coverages are evaluated in stages, it suffices that the dot area coverage may be changed in 0.5 % to 5% increments, on the standard scale, in 1% increments in accordance with the evaluation accuracy.
When a pattern is formed in such a manner that the FM halftone image and the AM halftone image are arranged adjacently under the aforementioned conditions, the quality of halftone dots can extremely sensitively reflect the influence of a development condition or the like, and the state of a developer can be easily detected by visual observation. Therefore, it is preferable from the viewpoint of the effect that a pattern of a halftone image is configured in accordance with the aforementioned conditions.

Due to the region having the FM halftone image of a predetermined area coverage being provided at a position adjacent to each of the AM halftone images formed adjacently and at different area coverages, when the standard image pattern is used, it becomes possible to correctly determine the degree of activity of the developer by setting, as a standard value, a region in which it is determined that adjacent halftone images have the same density by visual observation.

### Method for Evaluating Developer for Planographic printing plate and Method for Controlling quality of Planographic printing plate

The method for evaluating a developer for a planographic printing plate of the present invention contains at least: (A) producing a standard plate by exposing a photosensitive planographic printing plate precursor to form the standard image pattern and then developing the image with a standard developer; (B) producing a subject developer evaluation plate in the same manner as the (A) producing of the standard plate except that the developing is performed by using a developer to be evaluated; and (C) comparing the dot area coverage resulting from the standard plate with that resulting from the subject developer evaluation plate.

The method for controlling quality of a planographic printing plate of the present invention contains at least:(A) producing a standard plate by exposing a photosensitive planographic printing plate precursor to form the standard image pattern and then developing the image with a standard developer; (B) producing a subject developer evaluation plate in the same manner as that of the standard plate except that the developing is performed by using a developer to be evaluated; (C) comparing the dot area coverage resulting from the standard plate with that resulting from the subject developer evaluation plate; and (D) adjusting a condition of at least one of the exposing and the developing in a case where the difference between the dot area coverage resulting from the standard plate and that resulting from the subject developer evaluation plate is equal to or larger than a predetermined value.
The method for controlling quality of a planographic printing plate preferaly further having (E) performing, at least once in this order, the following cycle containing: producing a new subject developer evaluation plate in the same manner as that of the standard plate except that the developing is performed by using a developer to be evaluated, and at least one of the exposing and the developing is performed under the adjusted condition of at least one of the exposing and the developing; comparing the dot area coverage resulting from the standard plate with that resulting from the new subject developer evaluation plate; and adjusting a condition of at least one of the exposing and the developing in a case where the difference between the dot area coverage resulting from the standard plate and that resulting from the new subject developer evaluation plate is equal to or larger than a predetermined value.

The method for evaluating a developer for a planographic printing plate of the invention firstly performs the process of (A) producing a standard plate by exposing a photosensitive planographic printing plate precursor to form the standard image pattern and then developing the image with a standard developer. (The dots having the predetermined condition as described above may be sptetimes simply referred as the "dots" hereinbelow).

The dots formed by the process of (A) producing the standard plate may be provided in a part of the surface of a single specific planographic printing plate precursor. For example, about 20% of the surface area may be provided with the dots. Alternatively, a plurality of parts of the surface of a single specific planographic printing plate precursor may be provided with the dots.

The thus formed standard plate is to be a standard specimen for basic development conditions, and the developer preparation manner, treatment duration, and treatment temperature employed in this case are used as standard processes. Incidentally, it is not necessary to produce the standard plate to be an evaluation standard every time the evaluation is performed. Only one standard plate need be produced in an initial process of sequential processes in which the same plate-making processing is performed if evaluation and control are carried out for the resultants of the plate-making processes.

Next, a subject developer evaluation plate is produced in the process (B). The subject developer evaluation plate to be produced in this process is for confirming the fatigue state of a developer after of time lapses. The planographic printing plate is obtained by treating the specific planographic printing plate precursor similar to that used for producing the standard plate in the process (A) when the evaluation is required. The conditions for forming the subject developer evaluation plate such as the development temperature or the treatment duration are the same as those employed in the production of the standard plate in process (A).

Next, in the process (C), a dot area coverage (halftone-dot percentage (%)) of the standard plate and a dot area coverage of the subject developer evaluation plate are compared with each other. Thus, when compared with a sample having been subjected to standard development processing, the change of the condition(s) in exposure and/or development condition can be easily detected. In the case of the image pattern as specifically described above, visual evaluation of the change of the condition can be easily performed by reading out the number of images, in each of which the image density of the FM screen in the circular portion is the same as that of the image density of the AM screening in the peripheral portion.

In the invention, when an apparatus independently produces a planographic printing plate precursor on which a halftone image is to be formed and subjects the planographic printing plate precursor to a common plate-making process, the image evaluation and the quality control of the planographic printing plate can be carried out at the apparatus by placing the thus obtained planographic printing plate precursor between other planographic printing plate precursors at a predetermined interval and observing the plate-making state of the planographic printing plate precursor obtained by the invention and that of other precursors. Alternatively, the image evaluation and the quality control of the planographic printing plate can be carried out by forming a halftone image in a margin portion, such as a frame portion, of a planographic printing plate precursor to be subjected to the plate-making process, and observing the plate-making state of the printing plate.

The method for controlling quality of a planographic printing plate of the present invention has the process of (D) adjusting a condition of at least one of the exposing and the developing in a case where it turns out from the method for controlling quality of a planographic printing plate including the processes (A) to (C) that the difference between the dot area coverage resulting from the standard plate and that resulting from the subject developer evaluation plate is equal to or larger than a predetermined value. That is, the quality control method for the invention is a method for rationally controlling the quality of a planographic printing plate by adjusting the exposing process and/or the developing process on the basis of the feedback from the evaluation result obtained by the image evaluation method for the invention.

When the exposing process and/or the developing process is adjusted on the basis of the feedback of the predetermined value in the process (D), the density difference to be a criterion for the controlling (adjusting) may be properly determined depending on the quality required for the planographic printing plate. In general, the control of the exposing process and/or the developing process based on the feedback would be performed when the density difference of the halftone image in the standard plate (a standard sample) and that of the subject developer evaluation plate becomes 2.0 or higher.

Means for adjusting the condition(s) of the exposure and/or the development in process (D) is as follows.
When developability is deteriorated in an evaluated subject developer evaluation plate, namely, when the halftone-dot percentage of the halftone image is increased, the exposure condition can be increased, and/or the development condition can be activated. Also, when development is excessively carried out, namely, when the halftone-dot percentage of the halftone image is decreased, the exposure condition can be lowered, and/or the development condition can be moderated.

The following are examples of means for the counteracting the case where the difference in the halftone-dot percentages of the halftone images reaches equal to or higher than a predetermined value due to excessive development.

Exemplary means to be employed for Adjustment in Development
(1) Adding water to the developer.
(2) Adding dry ice to the developer.
(3) Blowing CO₂ gas into the developer.
(4) Decreasing a dilution ratio of a replenishing solution.
(5) Setting an amount of a replenishing solution (to be replenished) of the automatic developing apparatus to be smaller.
(6) Decreasing the development temperature.
(7) Shortening the development duration (increasing the speed of transportation of plates by the automatic developing apparatus).
(8) Decreasing the pressure of developing brushes of the automatic developing apparatus.
(9) Reducing the number of the developing brushes of the automatic developing apparatus.
(10) Decreasing the amount of sprayed developer.
(11) Stirring the developer.
(12) Replacing the used developer with a new developer.

Exemplary means to be employed for Adjustment in Exposure
(13) Decreasing the amount of light used for the exposure.
(14) Heating a positive planographic printing plate precursor for IR lasers before exposure.

On the other hand, the following are examples of means for the counteracting the case where the difference in the halftone-dot percentages of the halftone images reaches equal to or higher than a predetermined value due to deterioration of the developability.

Exemplary means to be employed for Adjustment in Development
(1) Adding a replenishing solution to the developer.
(2) Increasing a dilution ratio of a replenishing solution.
(3) Setting an amount of a replenishing solution (to be replenished) of the automatic developing apparatus to be larger.
(4) Raising the development temperature.
(5) Lengthening the development duration (increasing the speed of transportation of plates by the automatic developing apparatus).
(6) Increasing the pressure of developing brushes of the automatic developing apparatus.
(7) Increasing the number of the developing brushes of the automatic developing apparatus.
(8) Increasing the amount of sprayed developer.
(9) Replacing the used developer with a new developer.

Exemplary means to be employed for Adjustment in Exposure
(10) Increasing the amount of light used for the exposure.

In the case where the extent of the exposure (the amount of light used for the exposure) is controlled by the above-mentioned adjustment means, conditions such as the output of laser beam, beam diameter, scanning speed or exposure duration may be properly adjusted.

In the method for controlling the quality of the planographic printing plate of the invention, the method preferably further includes, after completing processes (A) to (D), the process of (E)producing a subject developer evaluation plate in a manner similar to that of the process (B) except that the exposure condition and/or development condition is adjusted. It is preferable that the processes (E), (C), and (D) are carried out in this order once or a plurality of times.
The development state of the planographic printing plate can be kept stable for a long duration by repeating the feedback of the result of the image evaluation to the exposure/development conditions as described above.

Details of the planographic printing plate used in the method for evaluating a developer and the method for controlling the quality thereof of the invention is explained hereinafter.
There is no particular limitation to the planographic printing plate precursor subjected to the evaluation in the invention. Considering effectiveness of the evaluation and control method in plate-making processes using a photosensitive positive planographic printing plate precursor which can be used for recording using infrared laser, explanation about such precursor is herein provided.
There is no particular limitation to the photosensitive positive planographic printing plate precursor as long as it has at least a support and a photosensitive layer which has at least an alkaline aqueous solution-soluble resin and a compound that absorbs light and generates heat, the photosensitive layer being provided on the support. The planographic printing plate which can be used in the invention can be obtained by exposing and developing the precursor.

Examples of the alkaline aqueous solution-soluble resin in the photosensitive layer include a polymer having a phenol group, an acrylic resin having an alkali-soluble group, and the like.
Examples of the polymer having a phenol group include a novolak resin and a resol resin. Examples thereof further include a polymer formed by polymerizing a monomer having a phenol group at a side chain (such as acryl amide having a phenol group, methacryl amide having a phenol group, acrylic ester having a phenol group, or metacrylic ester having a phenol group) and a polymer compound having hydroxystyrene as a polymerization component thereof.
Examples of the novolak resin include phenol formaldehyde resin, m-/p-mixed cresol formaldehyde resin, and phenol/cresol (m-, p-, o-, m-/p-mixture, m-/o-mixture or o-/p-mixture cresol may be used)-mixed formaldehyde resin.

Examples of the acrylic resin having an alkali-soluble group include an acrylic resin having, at the side chain thereof, an acidic group such as a sulfonamide group (-SO₂NH-R), a substituted sulfonamide acid group [such as -SO₂NHCOR, -SO₂NHS0₂R, or -CONHSO₂R], a carboxylic acid group, or the like.
Preferable examples of the acrylic resin having a sulfonamide group include polymers such as m-aminosulfonyl phenylmethacrylate, N-(p-aminosulfonylphenyl)methacrylamide, N-(p-aminosulfonylphenyl)acrylamide or the like.
When the novolak resin is used as the polymer used in the invention, the polymer preferably has a weight-average molecular weight of 500 to 20,000 and a number-average molecular weight of 200 to 10,000. When other polymers other than the novolak resin is used as the polymer used in the invention, the polymer preferably has a weight-average molecular weight of 5,000 to 300,000 and a number-average molecular weight of 800 to 250,000.
In the invention, the amount of the polymer added to the photosensitive layer is 30 to 99 mass%, preferably 50 to 99 mass%, and particularly preferably 65 to 99mass% relative to the total solid content of the photosensitive layer.

### Infrared absorbent

Known various pigments and dyes may be suitably employed as an infrared absorbent used in the planographic printing plate precursor. Examples of the dye that absorbs infrared rays include cyanine dyes described in JP-A No. 60-78787, methine dyes described in JP-A No. 58-194595, naphthoquinone dyes described in JP-A No. 60-63744, squarylium dyes described in JP-A No. 58-112792, cyanine dyes described in British Patent No. 434,875, cyanine dyes described in JP-A No. 59-216146, and the like. Particularly preferable examples of the dye include near infrared absorbing dyes represented by formulae (I) and (II) in US Patent No. 4,756,993. The amount of the infrared absorbent added to is preferably 0.01 to 50 mass%, and is more preferably 0.1 to 10 mass%, based on the total solid content of the photosensitive layer. The amount of dyes added to the photosensitive layer is particularly preferably 0.5 to 10 mass% based on the total solid content of the photosensitive layer, while the amount of pigments added to the photosensitive layer is 3.1 to 10 mass% based on the total solid content of the photosensitive layer.

### Other Component

Various additives can be added to the coating layer of the present invention as necessary.
For example, in order to adjust the solubility of the recording layer, a so-called dissolution inhibiting agent which reduces the solubility of the aqueous solution-soluble polymer to a developer can be preferably used as an additive to the recording layer. Examples of the dissolution inhibiting agent include an onium salt, an o-quinonediazide compound, an alkyl sulfonate ester and the like. Preferable examples thereof include a diazonium salt, a phosphonium salt, an iodonium salt, a sulfonium salt and the like. Among these onium salts, a diazonium salt, a quaternary ammonium salt and a sulfonium salt.
The photosensitive layer may further contain cyclic acid anhydrides, phenols, organic acids and the like in view of improving sensitivity. , The photosensitive layer may further contain a surfactant, an image coloring agent, a plasticizer and the like. In addition, an epoxy compound, vinyl ethers, a phenol compound having a hydroxymethyl group described in JP-A No. 8-276558, and a phenol compound having an alkoxymethyl group can be appropriately added to the photosensitive layer according to an intended purpose.
The photosensitive layer may further contain a print-out agent for obtaining a visual image directly after heating by exposure, dyes and pigments used as image coloring agents, and a plasticizer for imparting flexibility and the like to a coating film configurating the photosensitive layer.

### Layer Structure of Recording Layer

The recording layer of the photosensitive planographic printing plate may have any configuration such as a single-layer structure, a phase-separation structure or a multi-layer structure.
Examples of the single-layer structure include a photosensitive layers described JP-A No. 7-285275, International Publication No. 97/39894 and the like. Examples of the phase-separation structure include a photosensitive layer described in JP-A No. 11-44956 and the like, and examples of the multi-layer structure include a photosensitive layer described in JP-A No. 11-218914.
The photosensitive planographic printing plate precursor can be manufactured by coating a liquid containing the above-described components to be contained in the photosensitive layer onto an appropriate support. A protective layer, a resin intermediate layer, a back coating layer which layers will be described below, and the like can also be provided to the photosensitive planographic printing plate precursor in a similar manner as that of the photosensitive layer according to an intended purpose.
The coating amount of the photosensitive layer obtained after coating and drying is preferably in the range from 0.5 to 3.0 g/m² in terms of a solid content in the case that the photosensitive layer has the configuration of the single layer.

### Support

An aluminum plate is specifically preferable as the support used in the photosensitive planographic printing plate precursor in view of its size stability and its relatively low cost. Preferable examples of the aluminum plate include a pure aluminum plate, an aluminum alloy plate containing aluminum as a main component and a trace of different elements, and a plastic film onto which aluminum is provided by lamination or evaporation.
Various methods can be used for surface-roughening of the aluminum plate. Examples thereof include a mechanical surface-roughening method, an electrochemical surface-dissolving-and-roughening method, and a chemical surface-dissolving method. Examples of the mechanical surface-roughening method include known methods such as ball graining, brush graining, blast graining or the like. Examples of the electrochemical surface-dissolving-and-roughening method include a method which carries out the roughening by alternating current or direct current in an electrolytic solution such as hydrochloric acid or nitric acid. Examples of the surface-roughening method further include a method which uses the mechanical surface-roughening method and the electrochemical surface-dissolving-and-roughening method in combination. The surface-roughening method preferably include a process of surface-roughening performed in a hydrochloric acid-containing electrolytic solution.
The surface-roughened aluminum plate can be subjected to alkali etching treatment or neutralization treatment as necessary. Further, the aluminum plate can be subjected to anodization, which can be carried out as necessary, in view of increasing the water-retaining property and wear resistance of the surface thereof.

Various electrolytes which can form a porous oxide film can be used as an electrolyte used for the anodizing treatment of the aluminum plate. Examples of generally-used electrolyte include a sulphuric acid, a phosphoric acid, an oxalic acid and a mixture acid containing any of these.
After being subjected to the anodizing treatment, a hydrophilization treatment can be further applied to the surface of the aluminum plate as necessary. Examples of the hydrophilization treatment used in the present invention include a method using an alkali metal silicate solution such as an aqueous sodium silicate solution.
An undercoat layer can be further provided between the support and a photosensitive layer as necessary.

### Exposure

Scanning-exposure using an infrared laser can be used for the exposing process in the invention. Preferable examples of the means for the exposing include a semiconductor laser that emits infrared rays having the wavelength of 700 to 1,200 nm and an infrared laser using a solid high-output infrared laser such as a YAG laser.
The output of the laser is preferably 100 mV or more. In view of reducing the time length of the exposure, a multi-beam laser device can be preferably used. The time length of the exposure per one pigment is preferably 20 microseconds or less, and the amount of the energy of lasers irradiated to the precursor is preferably in the range of 10 to 500 mJ/cm².

### Development

After being subjected to the exposure, the photosensitive planographic printing plate precursor is preferably developed by using an alkali aqueous solution having a pH of 12 or more and substantially having no organic solvent.
Conventionally known alkali aqueous solutions can be used as the developer (hereinafter, a replenisher will be also referred to as the "developer"). Examples of the developer that exhibits the effect of the present invention among such conventionally-known alkali aqueous solutions include: a so-called "silicate developer", which is an aqueous solution having a pH of 12 or more and which contains either alkali silicate as a base or alkali silicate prepared by mixing a silicon compound with a base; and a so-called "non-silicate developer", which has no alkali silicate but contains a non-reducing sugar (an organic compound having a buffering effect) and a base.
In view of promotion of developability, suppression of developability, dispersion of development scum, and/or improvement of inking property of image portions of the planographic printing plate to be obtained, a variety of surfactants and/or organic solvents can be additionally mixed with the developer and the replenishing solution in accordance with necessity. Preferable examples of the surfactant include an anionic surfactant, a cationic surfactant, a nonionic surfactant and an amphoteric surfactant.
The planographic printing plate obtained by the development using the developer and the replenishing solution is subjected to a post-treatment. The post-treatment may be carried out by combining any of a treatment using washing water, a treatment using a rinsing solution containing a surfactant and the like, and a treatment using a desensitizing solution containing a gum arabic and/or a starch compound.

It is known that a large number of PS plates can be processed without replacing the developer in a development tank for a long period of time by adding an aqueous solution (a replenisher) having a higher alkalinity than that of the developer to the developer when the development is performed by using an automatic processor. This replenishment system can be also preferably used in the present invention. The planographic printing plate obtained via the development using the developer and the replenisher can be subjected to a post-treatment using washing water, a rinsing solution containing a surfactant and the like, and a desensitizing solution containing a gum arabic and/or a starch compound.

Recently, an automatic developing apparatus for a printing plate has been used widely in order to make the plate-making process rational and standardize the process in plate-making and printing industries. The automatic developing apparatus generally has a development part and a post-treatment part, is provided with a unit for transporting a printing plate, tanks for respective treatments, and a spraying unit, and carries out a development treatment by spraying respective treatment solutions pumped up by pumps to an exposed printing plate while horizontally transporting the printing plate. A method for treating a printing plate by transporting the printing plate by guide rolls provided in a tank filled with a treatment solution while immersing the printing plate in the treatment solution is also known recently. In such an automatic treatment, treatment can be carried out simultaneously with supplying replenishing solutions to the respective treatment solutions depending on the quantity of processed plates and operation duration.
Plate-making process largely affects the quality of images on a planographic printing plate obtained from the positive planographic printing plate precursor subjected to the process. The application of the method for controlling quality of a planographic printing plate of the invention to such a continuous development process enables stably providing a planographic printing plate which can form excellent images over a long period.
The thus-obtained planographic printing plate can be further subjected to a burning treatment in a case where the printing durability of the planographic printing plate is desired to be further increased.

### EXAMPLES

Hereinafter, the invention will be described along with examples, while the scope of the invention is not limited thereby.

### Peparation of Support

An aluminum plate (containing Al: 99.50 mass % or more, Si: 0.25 mass %, Fe: 0.40 mass %, Cu: 0.05 mass %, Mn: 0.05 mass %, Mg: 0.05 mass %, Zn: 0.05 mass %, Ti: 0.03 mass %) having a thickness of 0.3 mm was subjected to the following processes to prepare a support.
The surface of the aluminum plate was mechanically roughened with a rotating roller-shaped nylon brush while a suspension of quartz sand and water being supplied as an abrasion slurry solution to the surface of the aluminum plate. The surface was then subj ected to an etching treatment by being sprayed with an aqueous solution containing 26 mass % of NaOH at the temperature of 70°C, such that 6g/m² of the aluminum plate was dissolved. Subsequently, the surface of the aluminum plate was washed with well water by spraying. The surface was further subjected to a desmutting treatment by being sprayed with an aqueous solution containing 1 mass% nitric acid at the temperature of 30°C. Further, the surface was subjected to a continuous electrochemical surface-roughening treatment by applying a 60-Hz A.C. voltage in an aqueous solution containing 10 g/liter of nitric acid at the temperature of 50 °C under the conditions that the current density of 30 A/dm² at a peak value and the quantity of electricity of 220 C/dm² in total at the time of an anodizing treatment. Thereafter, the aluminum plate was subjected to an etching treatment by being sprayed with a solution containing 26 mass % of caustic soda at the temperature of 32°C, such that 0.20 g/m² of the aluminum plate was dissolved. The aluminum plate was then subjected to a desmutting treatment by being sprayed with an aqueous solution containing 15 mass % of sulfuric acid at the temperature of 30°C, and was washed with well water by spraying.

Subsequently, the surface of the aluminum plate was subjected to an anodic oxidation treatment by using a solution containing 170 g/liter of sulfuric acid (and additionally 0.5 mass % of aluminum ion) at the temperature of 43 °C under the condition that the current density of about 30 A/dm². The amount of the oxide layer thus finally formed was 2.7 g/m². The aluminum plate was then washed with well water by spraying.
The aluminum support thus obtained by being subjected to the anodic oxidation treatment was further subjected to an alkali metal silicate salt treatment (silicate treatment) by immersing the aluminum support in 1 a mass % of SODIUM SILICATE SOLUTION NO. 1 (trade name, manufactured by Showa Chemical Industry Co.,Ltd.: aqueous solution containing 17-18 mass% of Na₂O and 36-38mass% of SiO₂) at the temperature of 30 °C for 10 seconds. The aluminum support was then washed with well water by spraying. The amount of silicate adhered to the surface of the aluminum support was 5.5 g/m².

Subsequently, an undercoat layer having a coating amount of 0.02 g/m² was formed on the surface of the aluminum plate.

### Undercoating solution 1

- Compound P (molecular weight: 280,000, shown below) 0.1 g
- Methanol 100 g
- Water 1 g

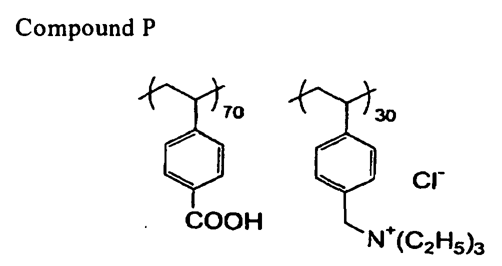

### Preparation of Photosensitive Layer

A coating liquid A having the following formulation was coated on the undercoat layer formed on the support by a wire bar and dried in a drying oven at 150 °C for 40 seconds, so as to form an under layer having the coating amount of 0.8 g/m².
A coating liquid B having the following formulation was further provided on the under layer by using a wire bar and dried in a drying oven at 150 °C for 40 seconds, so as to form an upper layer so that the total amount of the coating including the under layer and an upper layer became 1.0 g/m². A planographic printing plate precursor, which has the upper layer formed of the constituents of the coating liquid B, was thus obtained.

Formulation of Coating Liquid A
- Copolymer of N-(p-aminosulfonylphenyl)methacrylamide/methyl methacrylate/acrylonitrile=35/35/30 (mole ratio) (weight-average molecular weight: 65,000) · 3.5 g
- m,p-cresol novolak (m/p ratio = 6/4, weight-average molecular weight: 6,000) 0.6 g
- Infrared absorbent (cyanine dye A: shown below) 0.25 g
- Dye (ethyl violet having 6-hydroxy-β-naphthalene solfonate as a counter anion thereof) 0.15 g
- Bisphenol sulfone0.3 g
- Tetrahydrophthalic acid0.4 g
- Fluorine surfactant (trade name: MEGAFAC F-780, manufactured by Dainippon Ink & Chemicals Incorporated)0.02 g
- Methyl ethyl ketone60 g
- Propylene glycol monomethyl ether20 g
- γ-butyrolactone20 g

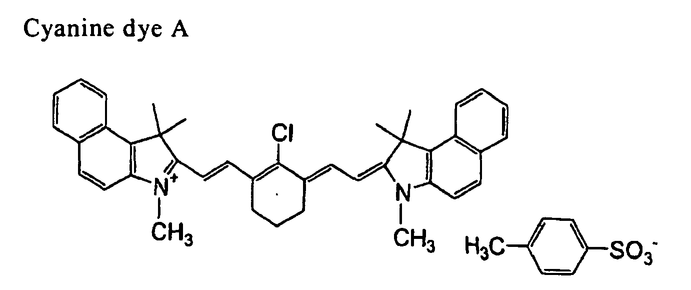

Formulation of Coating Liquid B
- Novolak resin (m-cresol/p-cresol/phenol=3/2/5 (mole ratio), weight-average molecular weight: 8,000) 1.7 g
- Infrared absorbent (cyanine dye A) 0.15 g
- Compound Q (shown below) 0.35 g
- Fluorine surfactant (trade name: MEGAFAC F-780, described above) 0.03 g
- Copolymer of tridecafluorooctyl methacrylate/2-adamantyl acrylate/2-carboxyethylmethacrylate (=30/50/20 (mole ratio), weight-average molecular weight: 30,000) 0.1 g
- Acrylic resin (see Table 1) 0.3 g
- Methyl ethyl ketone 33.0 g
- 1-methoxy-2-propanol 67.0 g

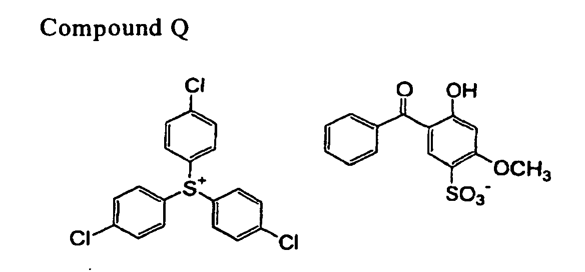

### Exposure

A peripheral part of an actual image, that is the portion to be cut and discarded on completion of printing matter formation, in the obtained planographic printing plate precursor (having a size of 650 mm × 550 mm and a thickness of 0.3 mm), was exposed so as to form the following standard image pattern (a control strip) of the invention having a size of 20 mm (length) × 250 mm (width) by using a plate setter (trade name: LUXCEL PLATESETTER 9000 CTP, manufactured by Fujifilm Corporation., output: 270 mW, rotation speed: 1,000 rpm, resolution: 2438 dpi).

### Standard Image Pattern

The standard image pattern used for the method for evaluating a developer for the planographic printing plate is prepared as follows.
As shown in Fig. 1A, a standard image pattern was prepared having 31 regions, each of which having an FM halftone image having a circular shape with a diameter of 10 µm, and other 31 regions, each of which having an AM halftone image having a rectangular shape and surrounding the peripheral portion of one of the 31 FM halftone image-containing regions. The area coverages of the FM halftone images were varied in 31 stages from No. 0 to No. 30 so that the digital area coverages of the FM halftone images were changed stepwise from 30% to 60%. The AM halftone images in the peripheral rectangular regions were formed in such a manner that the halftone images of the AM screening system formed at 175 lines per inch (1 inch is equivalent to 2.5 cm) were varied so that the digital area coverages of the AM halftone images were changed stepwise from 30% to 60% in 1% increments.
The standard image pattern was formed at a peripheral portion, which is to be cut off and removed after an image is formed, of a printing plate precursor formed as described above and is to be evaluated.
The developed standard image pattern was visually observed, and the region (same image density-region) in which a density of one of the AM halftone images located at the peripheral portion of one of the FM halftone images looked the same as the density of the one of the FM halftone images located at the central portions was detected so as to evaluate the developer.

### Development

The planographic printing plate precursor was developed as follows after the exposure.
20 L of an alkaline developer A (pH: about 13) having the following formulation was loaded into an immersion type development treatment tank of a commercialized automatic developing apparatus (trade name: LP-940H, manufactured by Fujifilm Corporation) and kept at 30°C. A second bath of the automatic developing apparatus was loaded with 8 L of tap water, and a third bath 8 L of the automatic developing apparatus was loaded with a finishing gum solution containing FP-2W (trade name, manufactured by Fujifilm Corporation) diluted with water at the ratio of FP-2W : water = 1 : 1.

Formulation of Alkaline development solution A
- D sorbitol 2.5 mass%
- Sodium hydroxide 0.85 mass%
- Pentasodium diethylenetriamine pentamethylenephosphonate 0.05 mass%
- Water 96.6 mass%

The development treatment was carried out for the exposed planographic printing plate while a developer replenishing solution B having the following formulation was supplied, with setting the control impedance value of the development replenishment built in the automatic developing apparatus at 43.0 ms/cm.

Formulation of Development replenishing solution B
- D sorbitol 5.6 mass%
- Sodium hydroxide 2.5 mass%
- Pentasodium diethylenetriamine pentamethylenephosphonate 0.2 mass%
- Water 91.7 mass%

The exposure and the development of 100 plates per a day were performed continuously for 3 months.
During the period of performing the exposure and the development, image evaluation was carried out every day by comparing the dot area coverage resulting from a standard sample, that is the standard image pattern formed on the planographic printing plate developed by using a standard developer, with a subject sample, that is the standard image pattern formed on the planographic printing plate developed by using a developer to be evaluated, and feeding back the evaluation results to the exposing process to adjust the exposure condition, whereby the control of the quality of obtained planographic printing plates was performed.

The adjustment of the exposure condition in this example was carried out by changing the amount of energy used for the exposure when the difference between the serial number of the same image density-region of the standard sample detected by the visual observation described above and that of the subject sample became 2 or more.
The standard sample herein employed was a plate formed on a first day of this exposure and the development experiment.

As a result, in the region of the serial No. 19, digital 30% FM screening halftone dots having the diameter of 10 µm was 47% on the plate, and digital 49% AM screening halftone dots at 175 screen lines per inch was 47 % on the plate. Thus, the halftone images of FM screening system and AM screening system appeared to have the same density under visual observation. Accordingly, the control strip indication (same image density-region) of the standard sample of the example was identified as the region No. 19.
Plates which are firstly formed in every day during the period of the experiment under the same conditions as those for forming the standard sample were used as the subject samples.
The halftone-dot percentage was measured by using a reflection densitometer (trade name: D 19C type, manufactured by GRETAG AG).

Concrete details of the experiment for the quality control were as follows.
On the 12th day, in the region No. 17, the image density of digital 30% FM screening halftone image having the diameter of 10 µm was 45% on the plate, and the image density of digital 46% AM screening halftone image having 175 screen lines per inch was 45 % on the subject plate. Namely, the image density of the FM halftone image and the AM halftone image appeared to have the same image density under visual observation. Accordingly, the control strip indication of the 12th-day's subject sample according to the present invention was the region No. 17.
Feedback of evaluation results was performed based on the method for controlling quality of a planographic printing plate of the invention by changing the amount of exposure to 240 mW. As a result thereof, a control strip of a thus obtained sample exhibited the control strip indication of the region No. 19, which is the same as the standard sample of the example.
On the 26th day, in the region No. 21, the image density of digital 30% FM screening halftone image having the diameter of 10 µm was 49% on the plate, and the image density of digital 41 % AM screening halftone image having 175 screen lines per inch was 49 % on the subject plate. Namely, the image density of the FM halftone image and the AM halftone image appeared to have the same image density under visual observation. Accordingly, the control strip indication of the 26th-day's subject sample according to the present invention was the region No. 21.
Feedback of evaluation results was performed based on the method for controlling quality of a planographic printing plate of the invention by changing the amount of exposure to 300 mW. As a result thereof, a control strip of a thus obtained sample exhibited the control strip indication of the region No. 19, which is the same as the standard sample of the example.

It is understood from the above result that the automatic developing apparatus could have worked in a satisfactory condition under which a desirable planographic printing plate can be obtained only for 12 days in a case of the absences of the method for evaluating a developer for a planographic printing plate and the method for controlling quality of a planographic printing plate of the invention. The above result shows the effectivity of the method for evaluating a developer for a planographic printing plate and the method for controlling quality of a planographic printing plate of the invention.

### Example 2

### Exposure

A peripheral part of an actual image, that is the portion to be cut and discarded on completion of printing matter formation, in the obtained planographic printing plate precursor (having a size of 650 mm × 550 mm and a thickness of 0.3 mm), was exposed so as to form the following standard image pattern (a control strip) of the invention having a size of 20 mm (length) × 250 mm (width) by using a plate setter (trade name: LUXCEL PLATESETTER 9000 CTP, manufactured by Fujifilm Corporation., output: 270 mW, rotation speed: 1,000 rpm, resolution: 2438 dpi).

### Development

The planographic printing plate precursor was developed as follows after the exposure.
20 L of an alkaline developer C (pH: about 13) having the following formulation was loaded into an immersion type development treatment tank of a commercialized automatic developing apparatus (trade name: LP-940H, manufactured by Fujifilm Corporation) and kept at 30°C. A second bath of the automatic developing apparatus was loaded with 8 L of tap water, and a third bath 8 L of the automatic developing apparatus was loaded with a finishing gum solution containing FP-2W (trade name, manufactured by Fujifilm Corporation) diluted with water at the ratio of FP-2W : water = 1 : 1.

Formulation of Alkaline development solution A
- SiO₂·K₂O (mole ratio: K₂O/ SiO₂ =1.1)4.0 mass%
- citric acid0.5 mass%
- Polyethyleneglycol (weight average molecular weight: 1,000)0.5 mass%
- Water 95.0 mass%

The development treatment was carried out for the exposed planographic printing plate (having a size of 650 mm × 550 mm and a thickness of 0.24 mm) while 35 ml of a developer replenishing solution D having the following formulation was supplied at times when each plates are developed.

Formulation of Development replenishing solution D
- SiO₂·K₂O (mole ratio: K₂O/ SiO₂ =1.1)5.0 mass%
- citric acid0.6 mass%
- Polyethyleneglycol (weight average molecular weight: 1,000)0.6 mass%
- Water93.8 mass%

The exposure and the development of 50 plates per a day were performed continuously for 60 days.
During the period of performing the exposure and the development, the image evaluation method of the invention was carried out every day and the evaluation results to the exposing process were fed back to adjust the exposure condition, whereby the control of the quality of obtained planographic printing plates was performed.

The standard sample herein employed was a plate formed on a first day of this exposure and the development experiment.
As a result, in the region of the serial No. 19, digital 30% FM screening halftone dots having the diameter of 10 µm was 47% on the plate, and digital 49% AM screening halftone dots at 175 screen lines per inch was 47 % on the plate. Thus, the halftone images of FM screening system and AM screening system appeared to have the same density under visual observation. Accordingly, the control strip indication (same image density-region) of the standard sample of the example was identified as the region No. 19.
Plates which are firstly formed in every day during the period of the experiment under the same conditions as those for forming the standard sample were used as the subject samples.
The halftone-dot percentage was measured by using a reflection densitometer (trade name: D 19C type, manufactured by GRETAG AG).

Concrete details of the experiment for the quality control were as follows.
On the 26th day, in the region No. 21, the image density of digital 30% FM screening halftone image having the diameter of 10 µm was 49% on the plate, and the image density of digital 51% AM screening halftone image having 175 screen lines per inch was 49 % on the subj ect plate. Namely, the image density of the FM halftone image and the AM halftone image appeared to have the same image density under visual observation. Accordingly, the control strip indication of the 26th-day's subject sample according to the present invention was the region No. 21.
Feedback of evaluation results was performed based on the method for controlling quality of a planographic printing plate of the invention by changing the amount of exposure to 300 mW. As a result thereof, a control strip of a thus obtained sample exhibited the control strip indication of the region No. 19, which is the same as the standard sample of the example.
On the 46th day, in the region No. 17, the image density of digital 30% FM screening halftone image having the diameter of 10 µm was 45% on the plate, and the image density of digital 47% AM screening halftone image having 175 screen lines per inch was 45 % on the subject plate. ·Namely, the image density of the FM halftone image and the AM halftone image appeared to have the same image density under visual observation. Accordingly, the control strip indication of the 46th-day's subject sample according to the present invention was the region No. 17.
Feedback of evaluation results was performed based on the method for controlling quality of a planographic printing plate of the invention by changing the amount of exposure to 240 mW. As a result thereof, a control strip of a thus obtained sample exhibited the control strip indication of the region No. 19, which is the same as the standard sample of the example.

It is understood from the above result that the automatic developing apparatus could have worked in a satisfactory condition under which a desirable planographic printing plate can be obtained only for 26 days in a case of the absences of the method for evaluating a developer for a planographic printing plate and the method for controlling quality of a planographic printing plate of the invention. The above result shows the effectivity of the method for evaluating a developer for a planographic printing plate and the method for controlling quality of a planographic printing plate of the invention.

### Example 3

The planographic printing plate precursor, the developing apparatus, and the developer used in Example 2 were also used in Example 3.

The exposure and the development of 40 plates per a day were performed continuously for 60 days.
During the period of performing the exposure and the development, the image evaluation method of the invention was carried out every day and the evaluation results to the exposing process were fed back to adjust the development condition, whereby the control of the quality of obtained planographic printing plates was performed.

The standard sample herein employed was a plate formed on a first day of this exposure and the development experiment.
As a result, in the region of the serial No. 19, digital 30% FM screening halftone dots having the diameter of 10 µm was 47% on the plate, and digital 49% AM screening halftone dots at 175 screen lines per inch was 47 % on the plate. Thus, the halftone images of FM screening system and AM screening system appeared to have the same density under visual observation. Accordingly, the control strip indication (same image density-region) of the standard sample of the example was identified as the region No. 19.
Plates which are firstly formed in every day during the period of the experiment under the same conditions as those for forming the standard sample were used as the subject samples.
The halftone-dot percentage was measured by using a reflection densitometer (trade name: D19C type, manufactured by GRETAG AG).

Concrete details of the experiment for the quality control were as follows.
On the 22nd day, in the region No. 21, the image density of digital 30% FM screening halftone image having the diameter of 10 µm was 49% on the plate, and the image density of digital 51 % AM screening halftone image having 175 screen lines per inch was 49 % on the subject plate. Namely, the image density of the FM halftone image and the AM halftone image appeared to have the same image density under visual observation. Accordingly, the control strip indication of the 22nd-day's subject sample according to the present invention was the region No. 21.
Feedback of evaluation results was performed based on the method for controlling quality of a planographic printing plate of the invention by changing the time length of the development from 12 seconds, which was an initially set time length, to 14 seconds. As a result thereof, a control strip of a thus obtained sample exhibited the control strip indication of the region No. 19, which is the same as the standard sample of the example.
On the 52nd day, in the region No. 17, the image density of digital 30% FM screening halftone image having the diameter of 10 µm was 45% on the plate, and the image density of digital 47% AM screening halftone image having 175 screen lines per inch was 45 % on the subject plate. Namely, the image density of the FM halftone image and the AM halftone image appeared to have the same image density under visual observation. Accordingly, the control strip indication of the 52nd-day's subject sample according to the present invention was the region No. 17.
Feedback of evaluation results was performed based on the method for controlling quality of a planographic printing plate of the invention by changing the temperature of the development from 30°C, which was an initially set temperature, to 28°C. As a result thereof, a control strip of a thus obtained sample exhibited the control strip indication of the region No. 19, which is the same as the standard sample of the example.

It is understood from the above result that the automatic developing apparatus could have worked in a satisfactory condition under which a desirable planographic printing plate can be obtained only for 22 days in a case of the absences of the method for evaluating a developer for a planographic printing plate and the method for controlling quality of a planographic printing plate of the invention. The above result shows the effectivity of the method for evaluating a developer for a planographic printing plate and the method for controlling quality of a planographic printing plate of the invention.

## Claims

1. A standard image pattern (10) for use in controlling a process of making printing plates, comprising:
a plurality of AM halftone images (12), each of which is formed of dots according to Amplitude Modulation Screening, and each of which has an area coverage that is different from that of the others; and
a plurality of FM halftone images (14), which are formed of dots according to Frequency Modulation Screening, each image of which is adjacent to a respective one of the plurality of the AM halftone images (12), and which have a predetermined area coverage.

2. The standard image pattern according to claim 1, wherein the area coverages of the AM halftone images are varied stepwise.

3. The standard image pattern according to claim 1 or claim 2, wherein the FM halftone images (14) are each formed by a circular image, the diameter of which is in the range of 10 µm to 75 µm.

4. The standard image pattern according to any one of claims 1 to 3, wherein the number of screen lines of the AM halftone images (12) is in the range of 31,5 to 118, 1 lines per cm (80 lines per inch to 300 lines per inch), and the area coverage of the FM halftone images is in the range of 30% to 70%.

5. A method for evaluating a developer for a planographic printing plate, comprising:
producing a standard plate by exposing a photosensitive planographic printing plate precursor to form the standard image pattern (10) of any one of claims 1 to 4 and then developing the image with a standard developer;
producing a subject developer evaluation plate in the same manner as that of the standard plate except that the developing is performed by using a developer to be evaluated; and
comparing the dot area coverage resulting from the standard plate with that resulting from the subject developer evaluation plate.

6. A method for controlling quality of a planographic printing plate, comprising:
producing a standard plate by exposing a photosensitive planographic printing plate precursor to form the standard image pattern (10) of any one of claims 1 to 4 and then developing the image with a standard developer;
producing a subject developer evaluation plate in the same manner as that of the standard plate except that the developing is performed by using a developer to be evaluated;
comparing the dot area coverage resulting from the standard plate with that resulting from the subject developer evaluation plate; and
adjusting a condition of at least one of the exposing and the developing in a case where the difference between the dot area coverage resulting from the standard plate and that resulting from the subject developer evaluation plate is equal to or larger than a predetermined value.

7. The method for controlling quality of a planographic printing plate according to claim 6, wherein the photosensitive planographic printing plate
precursor comprises: a support; and a photosensitive layer which comprises an alkaline aqueous solution-soluble resin and a compound that absorbs light and generates heat, the photosensitive layer being provided on the support.

8. The method according to any one of claims 6 and 7, further comprising performing, at least once in this order, the following cycle comprising:
producing a new subject developer evaluation plate in the same manner as that of the standard plate except that the developing is performed by using a developer to be evaluated, and at least one of the exposing and the developing is performed under the adjusted condition of at least one of the exposing and the developing;
comparing the dot area coverage resulting from the standard plate with that resulting from the new subject developer evaluation plate; and
adjusting a condition of at least one of the exposing and the developing in a case where the difference between the dot area coverage resulting from the standard plate and that resulting from the new subject developer evaluation plate is equal to or larger than a predetermined value.

## Patentansprüche

1. Standardbildmuster (10) zur Verwendung bei der Kontrolle eines Prozesses zur Herstellung von Druckplatten, welches Folgendes umfasst:
mehrere AM-Halbtonbilder (12), von denen jedes in Übereinstimmung mit Amplituden-Modulations-Screening aus Punkten gebildet ist, und von denen jedes eine Bereichsabdeckung aufweist, die sich von der der anderen unterscheidet; und
mehrere FM-Halbtonbilder (14), die in Übereinstimmung mit Frequenz-Modulations-Screening aus Punkten gebildet sind, wobei jedes dieser Bilder neben einem entsprechenden der mehreren der AM-Halbtonbilder (12) liegt, und die eine vorbestimmte Bereichsabdeckung aufweisen.

2. Standardbildmuster nach Anspruch 1, wobei die Bereichsabdeckungen der AM-Halbtonbilder schrittweise variiert werden.

3. Standardbildmuster nach Anspruch 1 oder Anspruch 2, wobei die FM-Halbtonbilder (14) jeweils durch ein rundes Bild gebildet werden, dessen Durchmesser im Bereich von 10 µm bis 75 µm liegt.

4. Standardbildmuster nach einem der Ansprüche 1 bis 3, wobei die Anzahl der Bildschirmlinien der AM-Halbtonbilder (12) im Bereich von 31,5 bis 118,1 Linien pro cm (80 Linien pro Zoll bis 300 Linien pro Zoll) liegt, und die Bereichsabdeckung der FM-Halbtonbilder im Bereich von 30 % bis 70 % liegt.

5. Verfahren zum Evaluieren eines Entwicklers für eine Flachdruckplatte, welches Folgendes umfasst:
Herstellen einer Standardplatte durch Belichten eines fotoempfindlichen Flachdruckplatten-Vorläufers zum Bilden des Standardbildmusters (10) nach einem der Ansprüche 1 bis 4 und anschließendes Entwickeln des Bildes mit einem Standardentwickler;
Herstellen einer Subjekt-Entwicklerevaluierungsplatte in gleicher Art und Weise wie die der Standardplatte, außer dass das Entwickeln durch Verwendung eines zu evaluierenden Entwicklers durchgeführt wird; und
Vergleichen der Punktbereichsabdeckung, die aus der Standardplatte resultiert, mit der, die aus der Subjekt-Entwicklerevaluierungsplatte resultiert.

6. Verfahren zum Kontrollieren der Qualität einer Flachdruckplatte, welches Folgendes umfasst:
Herstellen einer Standardplatte durch Belichten eines fotoempfindlichen Flachdruckplatten-Vorläufers zum Bilden des Standardbildmusters (10) nach einem der Ansprüche 1 bis 4 und anschließendes Entwickeln des Bildes mit einem Standardentwickler;
Herstellen einer Subjekt-Entwicklerevaluierungsplatte in gleicher Art und Weise wie die der Standardplatte, außer dass das Entwickeln durch Verwendung eines zu evaluierenden Entwicklers durchgeführt wird;
Vergleichen der Punktbereichsabdeckung, die aus der Standardplatte resultiert, mit der, die aus der Subjekt-Entwicklerevaluierungsplatte resultiert; und
Anpassen einer Bedingung von mindestens entweder der Belichtung oder der Entwicklung in einem Fall, in dem der Unterschied zwischen der Punktbereichsabdeckung, die aus der Standardplatte resultiert, und der, die aus der Subjekt-Entwicklerevaluierungsplatte resultiert, gleich einem oder größer als ein vorbestimmten/r Wert ist.

7. Verfahren zum Kontrollieren der Qualität einer Flachdruckplatte nach Anspruch 6, wobei der fotoempfindliche Flachdruckplatten-Vorläufer Folgendes umfasst: einen Träger und eine fotoempfindliche Schicht, welche ein alkalisches wässriges lösungslösliches Harz und eine Verbindung, die Licht absorbiert und Wärme erzeugt, umfasst, wobei die fotoempfindliche Schicht auf dem Träger bereitgestellt ist.

8. Verfahren nach einem der Ansprüche 6 und 7, welches ferner das Durchführen, mindestens einmal in dieser Reihenfolge, des folgenden Zyklus umfasst, welcher Folgendes umfasst:
Herstellen einer neuen Subjekt-Entwicklerevaluierungsplatte in gleicher Art und Weise wie die der Standardplatte, außer dass das Entwickeln unter Verwendung eines zu evaluierenden Entwicklers durchgeführt wird und mindestens entweder das Belichten oder das Entwickeln unter den angepassten Bedingungen mindestens entweder des Belichtens oder des Entwickelns durchgeführt wird;
Vergleichen der Punktbereichsabdeckung, die aus der Standardplatte resultiert, mit der, die aus der neuen Subjekt-Entwicklerevaluierungsplatte resultiert; und
Anpassen einer Bedingung von mindestens entweder der Belichtung oder der Entwicklung in einem Fall, in dem der Unterschied zwischen der Punktbereichsabdeckung, die aus der Standardplatte resultiert, und der, die aus der neuen Subjekt-Entwicklerevaluierungsplatte resultiert, gleich einem oder größer als ein vorbestimmten/r Wert ist.

## Revendications

1. Motif d'image standard (10) à utiliser dans la commande d'un processus de réalisation de plaques d'impression, comprenant :
une pluralité d'images en demi-teinte AM (12), chacune d'elles étant formée de points selon un Tramage à Modulation d'Amplitude et chacune d'elles a une couverture de zone qui diffère de celle des autres ; et
une pluralité d'images en demi-teinte FM (14), qui sont formées de points selon un Tramage à Modulation de Fréquence, dont chaque image est adjacente à une image respective de la pluralité des images en demi-teinte AM (12), et qui ont une couverture de zone prédéterminée.

2. Motif d'image standard selon la revendication 1, dans lequel les couvertures de zone des images en demi-teinte AM sont variées par échelon.

3. Motif d'image standard selon la revendication 1 ou la revendication 2, dans lequel les images en demi-teinte FM (14) sont chacune formées par une image circulaire, dont le diamètre est dans la plage de 10 µm à 75 µm.

4. Motif d'image standard selon l'une quelconque des revendications 1 à 3, dans lequel le nombre de lignes de trame des images en demi-teinte AM (12) est dans la plage de 31,5 à 118,1 lignes par cm (80 lignes par pouce à 300 lignes par pouce) et la couverture de zone des images en demi-teinte FM est dans la plage de 30 % à 70 %.

5. Procédé pour évaluer un développeur pour une plaque d'impression planographique, comprenant :
la production d'une plaque standard en exposant un précurseur de plaque d'impression planographique photosensible pour former le motif d'image standard (10) selon l'une quelconque des revendications 1 à 4 et en développant ensuite l'image avec un développeur standard;
la production d'une plaque d'évaluation de développeur sujet de la même manière que celle de la plaque standard sauf que le développement est effectué en utilisant un développeur à évaluer ; et
la comparaison'de la couverture de zone de point résultant de la plaque standard à celle résultant de la plaque d'évaluation de développeur sujet.

6. Procédé pour maîtriser la qualité d'une plaque d'impression planographique, comprenant :
la production d'une plaque standard en exposant un précurseur de plaque d'impression planographique photosensible pour former le motif d'image standard (10) selon l'une quelconque des revendications 1 à 4 et en développant ensuite l'image avec un développeur standard ;
la production d'une plaque d'évaluation de développeur sujet de la même manière que celle de la plaque standard sauf que le développement est effectué en utilisant un développeur à évaluer ;
la comparaison de la couverture de zone de point résultant de la plaque standard à celle résultant de la plaque d'évaluation de développeur sujet ; et
l'ajustement d'un état d'au moins un de l'exposition et du développement dans un cas où la différence entre la couverture de zone de point résultant de la plaque standard et celle résultant de la plaque d'évaluation de développeur sujet est égale ou supérieure à une valeur prédéterminée.

7. Procédé pour maîtriser la qualité d'une plaque d'impression planographique selon la revendication 6, dans lequel le précurseur de plaque d'impression planographique photosensible comprend : un support ; et une couche photosensible qui comprend une résine soluble dans une solution aqueuse alcaline et un composé qui absorbe la lumière et produit de la chaleur, la couche photosensible étant disposée sur le support.

8. Procédé selon l'une quelconque des revendications 6 et 7, comprenant en outre l'exécution, au moins une fois dans cet ordre, du cycle suivant comprenant :
la production d'une nouvelle plaque d'évaluation de développeur sujet de la même manière que celle de la plaque standard sauf que le développement est effectué en utilisant un développeur à évaluer, et au moins un de l'exposition et du développement est effectué sous l'état ajusté d'au moins un de l'exposition et du développement ;
la comparaison de la couverture de zone de point résultant de la plaque standard à celle résultant de la nouvelle plaque d'évaluation de développeur sujet ; et
l'ajustement d'un état d'au moins un de l'exposition et du développement dans un cas où la différence entre la couverture de zone de point résultant de la plaque standard et celle résultant de la nouvelle plaque d'évaluation de développeur sujet est égale ou supérieure à une valeur prédéterminée.
